# EUROPEAN PATENT APPLICATION

(11) **EP 3 176 821 A1**
(43) Date of publication of application: **07.06.2017**
(21) Application number: 16197690.7
(22) Date of filing: 08.11.2016
(51) Int. Cl.: H01L 23/488, H01L 21/60, H01L 25/18

(54) **SEMICONDUCTOR DEVICE WITH A BARRIER LAYER FORMED BY ELECTROMIGRATION**

(30) Priority: 04.12.2015 JP 2015237931
(71) Applicant: TOYOTA JIDOSHA KABUSHIKI KAISHA, Toyota-shi, Aichi 471-8571 (JP)
(72) Inventor: KADOGUCHI, Takuya, Toyota-shi, Aichi 471-8571 (JP); TAKE, Naoya, Toyota-shi, Aichi 471-8571 (JP)
(74) Representative: TBK

(57) **Abstract**

A semiconductor device (10, 50) includes a semiconductor element (20, 70, 80, 90, 100) and an electrically conductive member (14, 66, 68, 74, 84). The semiconductor element (e.g. a diode (20, 90, 100) or an IGBT (70, 80)) is configured to allow an electric current to flow from a first electrode (21, 71, 81, 91, 101) to a second electrode (22, 72, 82, 92, 102) and prevent an electric current flowing from the second electrode (22, 72, 82, 92, 102) to the first electrode (21, 71, 81, 91, 101). The conductive member (14, 66, 68, 74, 84) is joined with the second electrode (22, 72, 82, 92, 102) (e.g., the cathode electrode of the diode (20, 90, 100) or the emitter electrode of the IGBT (70, 80)) via a solder joint layer (34, 77, 87, 98, 108). Surface of the second electrode (22, 72, 82, 92, 102) in contact with the solder joint layer (34, 77, 87, 98, 108) mainly comprises nickel, and surface of the conductive member (14, 66, 68, 74, 84) in contact with the solder joint layer (34, 77, 87, 98, 108) mainly comprises copper. The solder joint layer (34, 77, 87, 98, 108) comprises first and second compound layers (34a, 77a, 87a, 98a, 108a, 34c, 77c, 87c, 98c, 108c). The first compound layer (34a, 77a, 87a, 98a, 108a) is located at an interface with the second electrode (22, 72, 82, 92, 102) and comprises a nickel-tin based intermetallic compound. The second compound layer (34c, 77c, 87c, 98c, 108c) is located at an interface with the conductive member (14, 66, 68, 74, 84) and comprises a copper-tin based intermetallic compound. When electrons flow from the conductive member (14, 66, 68, 74, 84) toward the semiconductor element (20, 70, 80, 90, 100), the copper-tin based intermetallic compound that configures the second compound layer (34c, 77c, 87c, 98c, 108c) moves toward the first compound layer (34a, 77a, 87a, 98a, 108a) due to electromigration, and is deposited on the first compound layer (34a, 77a, 87a, 98a, 108a). Consequently, a barrier layer (34d, 77d, 87d, 98d, 108d) is formed on the first compound layer (34a, 77a, 87a, 98a, 108a).

## Description

### TECHNICAL FIELD

The disclosure herewith relates to a semiconductor device.

### DESCRIPTION OF RELATED ART

Japanese Patent Application Publication No. 2002-270736 (JP 2002-270736 A) discloses a semiconductor device. This semiconductor device includes a semiconductor element, and an electrically conductive member joined with an electrode of the semiconductor element. The electrode of the semiconductor element and the electrically conductive member are joined by soldering, and a solder joint layer is formed therebetween. Generally, in a case of joining two members with solder, a nickel film is commonly formed on a surface of each of the members, for the purpose of improving solderability, for example. Notably, the solder mentioned in the present teachings is not limited to an alloy of tin and lead, and includes various lead-free solder composed mainly of tin.

### BRIEF SUMMARY

When electric current flows in the semiconductor element and the electrically conductive member, a temperature of the semiconductor element and a temperature of the electrically conductive member rise. The semiconductor element, in particular, generates a larger amount of heat than the electrically conductive member, and hence the temperature of the semiconductor element tends to be higher than that of the electrically conductive member. Accordingly, at an interface between the electrode of the semiconductor element and the solder joint layer, nickel diffuses from the nickel film to the solder joint layer, to thereby allow nickel-tin based intermetallic compound (e.g., Ni₃Sn₄) to be generated easily. If such intermetallic compound is excessively generated, defects such as voids occur, for example, which can cause malfunctions such as a decrease in joint strength, an increase in electrical resistance, and the like.

In view of the above-described problems, the present disclosure provides an art capable of suppressing generation of intermetallic compound at the interface between the electrode of the semiconductor element and the solder joint layer.

A semiconductor device herein disclosed includes a semiconductor element and an electrically conductive member. The semiconductor element includes a first electrode and a second electrode, and is configured to allow electric current to flow from the first electrode to the second electrode and prevent electric current flowing from the second electrode to the first electrode. The electrically conductive member is joined with the second electrode of the semiconductor element via a solder joint layer. A surface of the second electrode in contact with the solder joint layer is made of metallic material at least mainly comprising nickel, and a surface of the electrically conductive member in contact with the solder joint layer is made of metallic material at least mainly comprising copper. The solder joint layer includes a first compound layer and a second compound layer. The first compound layer is located at an interface with the second electrode and comprises nickel-tin based intermetallic compound. The second compound layer is located at an interface with the electrically conductive member and comprises copper-tin based intermetallic compound.

In the above-described semiconductor device, the semiconductor element only allows electric current that flows from the first electrode to the second electrode. Accordingly, in the solder joint layer joined with the second electrode, electric current can flow only in a direction from the semiconductor element toward the electrically conductive member. In this case, a flow of electrons in the solder joint layer is always along a direction from the electrically conductive member toward the semiconductor element. Due to this unidirectional flow of electrons, the copper-tin based intermetallic compound of the second compound layer moves toward the first compound layer, and is deposited on the first compound layer. Such a phenomenon is referred to as electromigration. If the first compound layer is covered with the copper-tin based intermetallic compound, diffusion of nickel from the second electrode to the solder joint layer is suppressed. Generation of intermetallic compound at the interface between the second electrode and the solder joint layer is thereby suppressed. On the other hand, at the interface between the electrically conductive member and the solder joint layer, the temperature thereof is relatively low, and hence growth of the second compound layer is allowably small.

### BRIEF DESCRIPTION OF THE DRAWINGS

FIG. 1 is a cross-sectional view that shows a semiconductor device 10 in Embodiment 1;
FIG. 2 is a circuit diagram that shows an electrical configuration of the semiconductor device 10 in Embodiment 1;
FIG. 3 schematically shows a joint structure by a solder joint layer 34, between a second electrode 22 of a semiconductor element 20 and a heat sink 14;

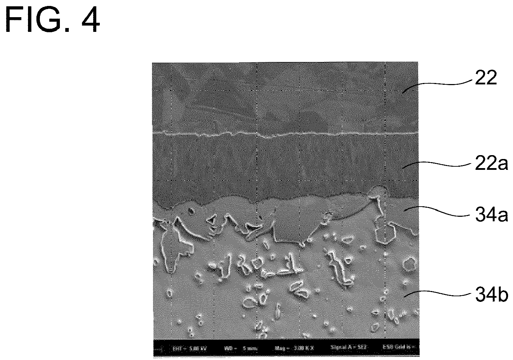

FIG. 4 is an electron microscopic photograph that shows a portion IV in FIG. 3;
FIG. 5 schematically shows formation of a barrier layer 34d by electromigration;
Each of FIGS. 6A and 6B shows an electron microscopic photograph that shows the barrier layer 34d formed by electromigration;
FIG. 7 schematically shows a joint structure by a solder joint layer 32, between a first electrode 21 of the semiconductor element 20 and a positive terminal 16;
FIG. 8 is a plan view that shows a semiconductor device 50 in Embodiment 2;
FIG. 9 shows an internal structure of the semiconductor device 50 in Embodiment 2. It should be noted that a first heat sink 62, a second heat sink 64, and a part of a seal body 52 are omitted;
FIG. 10 is a cross-sectional view on a line X-X in FIG. 8;
FIG. 11 is a cross-sectional view on a line XI-XI in FIG. 9;
FIG. 12 is a circuit diagram that shows an electrical configuration of the semiconductor device 50 in Embodiment 2;
FIG. 13 shows an electric power control device 120, which is one example of using the semiconductor device 50, the electric power control device 120 using a plurality of the semiconductor devices 50;
FIG. 14A is an enlarged view of a portion A in FIG. 10, FIG. 14B is an enlarged view of a portion B in FIG. 10, FIG. 14C is an enlarged view of a portion C in FIG. 11, and FIG. 14D is an enlarged view of a portion D in FIG. 11; and
FIG. 15A corresponds to FIG. 14A and schematically shows formation of a barrier layer 77d in a solder joint layer 77, FIG. 15B corresponds to FIG. 14B and schematically shows formation of a barrier layer 87d in a solder joint layer 87, FIG. 15C corresponds to FIG. 14C and schematically shows formation of a barrier layer 98d in a solder joint layer 98, and FIG. 15D corresponds to FIG. 14D and schematically shows formation of a barrier layer 108d in a solder joint layer 108.

### DETAILED DESCRIPTION

Representative, non-limiting examples of the present invention will now be described in further detail with reference to the attached drawings. This detailed description is merely intended to teach a person of skill in the art further details for practicing preferred aspects of the present teachings and is not intended to limit the scope of the invention. Furthermore, each of the additional features and teachings disclosed below may be utilized separately or in conjunction with other features and teachings to provide improved semiconductor devices, as well as methods for using and manufacturing the same.

Moreover, combinations of features and steps disclosed in the following detailed description may not be necessary to practice the invention in the broadest sense, and are instead taught merely to particularly describe representative examples of the invention. Furthermore, various features of the above-described and below-described representative examples, as well as the various independent and dependent claims, may be combined in ways that are not specifically and explicitly enumerated in order to provide additional useful embodiments of the present teachings.

All features disclosed in the description and/or the claims are intended to be disclosed separately and independently from each other for the purpose of original written disclosure, as well as for the purpose of restricting the claimed subject matter, independent of the compositions of the features in the embodiments and/or the claims. In addition, all value ranges or indications of groups of entities are intended to disclose every possible intermediate value or intermediate entity for the purpose of original written disclosure, as well as for the purpose of restricting the claimed subject matter.

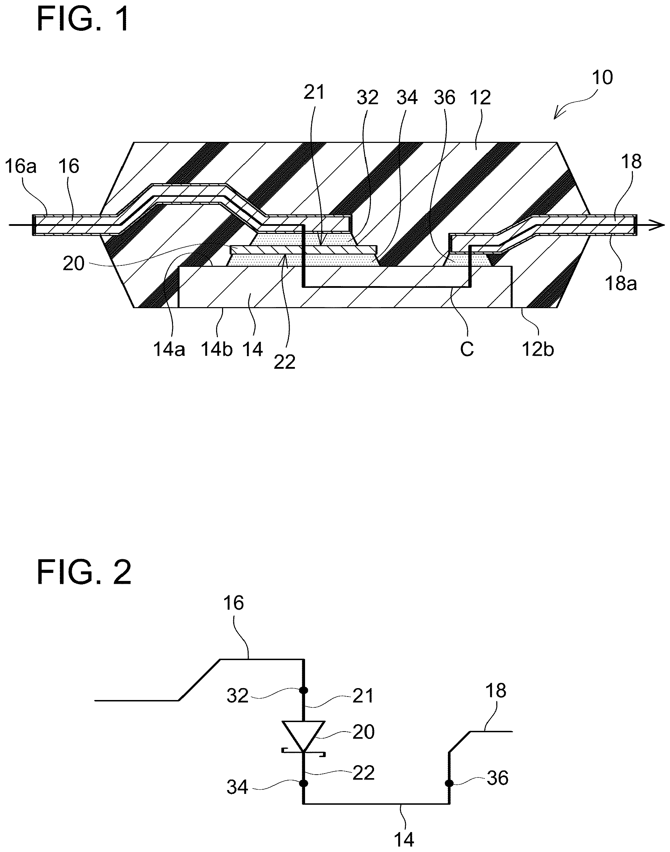

With reference to the drawings, a semiconductor device 10 in Embodiment 1 will be described. As shown in FIGS. 1 and 2, the semiconductor device 10 includes a semiconductor element 20, and a seal body 12 that seals the semiconductor element 20 therein. The seal body 12 is made of insulating material. The seal body 12 in the present embodiment is the one made of resin material and formed by molding. Notably, the seal body 12 may be made of various sealing materials (or molding materials) such as sealing material for a power semiconductor element can be adopted as appropriate.

The semiconductor element 20 includes a first electrode 21 and a second electrode 22. The first electrode 21 is located on an upper surface of the semiconductor element 20, and the second electrode 22 is located on a lower surface of the semiconductor element 20. The semiconductor element 20 includes a diode, the first electrode 21 is an anode electrode of the diode, and the second electrode 22 is a cathode electrode of the diode. Accordingly, the semiconductor element 20 allows electric current to flow from the first electrode 21 to the second electrode 22 and prevents electric current from flowing from the second electrode 22 to the first electrode 21. As one example, the semiconductor element 20 in the present embodiment is a power semiconductor element that uses silicon carbide (SiC), and its allowable electric current density is 25 A/mm² or higher. Notably, although the semiconductor element 20 in the present embodiment is a Schottky barrier diode, it may also be a pn junction diode.

Here, the terms of an upper surface and a lower surface in the present specification are expressions for distinguishing, for convenience, between two surfaces located on mutually opposite sides of each member, respectively. In other words, a surface referred to as an upper surface in the present specification does not mean that it is located vertically above when the semiconductor device 10 is used. The same applies to a surface referred to as a lower surface.

The semiconductor device 10 further includes a positive terminal 16, a heat sink 14, and a negative terminal 18. The positive terminal 16 is electrically connected to the first electrode 21 (the anode electrode) of the semiconductor element 20. The heat sink 14 is electrically connected to the second electrode 22 (the cathode electrode) of the semiconductor element 20. The negative terminal 18 is electrically connected to the heat sink 14. The semiconductor device 10 is thereby configured such that electric current C that flows from the positive terminal 16 to the negative terminal 18 is allowed on one hand, and electric current that flows in a direction reverse thereto is prevented on the other hand. The structure of the semiconductor device 10 will hereinafter be described in details.

The positive terminal 16 extends from an outside of the seal body 12 to an inside of the seal body 12. The positive terminal 16 is an electrically conductive member, and can be made of copper or other metallic materials, for example. A surface of the positive terminal 16 is covered with a nickel film 16a. The nickel film 16a is a film of metallic material at least mainly comprising nickel. The nickel film 16a may be an electro nickel plating coating or an electroless nickel plating coating, for example. The positive terminal 16 is soldered to the first electrode 21 (the anode electrode) of the semiconductor element 20, inside the seal body 12. Accordingly, the positive terminal 16 is joined with the first electrode 21 of the semiconductor element 20 via a solder joint layer 32. The positive terminal 16 is thereby electrically connected to the first electrode 21 of the semiconductor element 20. Notably, the solder in the present embodiment is not limited to an alloy of lead and tin, and includes various lead-free solder composed mainly of tin.

The heat sink 14 is an electrically conductive member. The heat sink 14 is a generally plate-shaped member, and has an upper surface 14a and a lower surface 14b. The heat sink 14 is made of metallic material at least mainly comprising copper (e.g., pure copper), and the copper is exposed on its upper surface 14a. The upper surface 14a of the heat sink 14 is located inside the seal body 12, and soldered to the second electrode 22 (the cathode electrode) of the semiconductor element 20. Accordingly, a solder joint layer 34 is formed between the second electrode 22 of the semiconductor element 20 and the heat sink 14, and the second electrode 22 of the semiconductor element 20 is joined with the heat sink 14 via the solder joint layer 34. The second electrode 22 of the semiconductor element 20 is thereby electrically connected to the heat sink 14.

The lower surface 14b of the heat sink 14 is exposed on a lower surface 12b of the seal body 12. The heat sink 14 thereby functions as a heat dissipation member that dissipates heat of the semiconductor device 10 to an outside. When the electric current C flows in the semiconductor device 10 (see FIG. 1), the semiconductor element 20 generates heat, in particular. The heat generated by the semiconductor element 20 is transferred to the heat sink 14 via the solder joint layer 34, and dissipated from the lower surface 14b of the heat sink 14 to the outside. The semiconductor device 10 is usually disposed such that the lower surface 14b of the heat sink 14 is in contact with a cooler (not shown). Overheating of the semiconductor element 20 is thereby prevented.

The negative terminal 18 extends from the outside of the seal body 12 to the inside of the seal body 12. The negative terminal 18 is an electrically conductive member, and may be made of copper or other metallic materials, for example. A surface of the negative terminal 18 is covered with a nickel film 18a, as in the positive terminal 16 mentioned above. The negative terminal 18 is soldered to the heat sink 14, inside the seal body 12. Accordingly, a solder joint layer 36 is formed between the negative terminal 18 and the heat sink 14, and the negative terminal 18 is joined with the heat sink 14 via the solder joint layer 36.

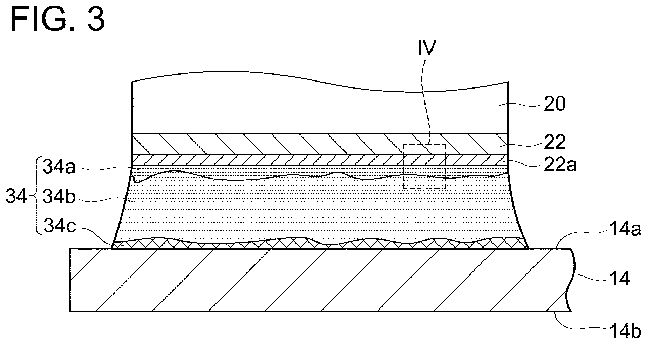

Next, with reference to FIG. 3, a joint structure by the solder joint layer 34 will be described. As mentioned above, the second electrode 22 of the semiconductor element 20 is joined with the heat sink 14 via the solder joint layer 34. Generally, in a case of joining two members with solder, intermetallic compound is generated at an interface between the solder and each of the members, thereby allowing the two members to be joined with each other via the solder joint layer. In a case of the present embodiment, as shown in FIG. 3, the second electrode 22 of the semiconductor element 20 has a nickel film 22a, and a surface of the second electrode 22 in contact with the solder joint layer 34 comprises nickel-based metallic material. Accordingly, the solder joint layer 34 has a first compound layer 34a mainly comprising nickel-tin based intermetallic compound (e.g., Ni₃Sn₄) at an interface with the second electrode 22. On the other hand, the upper surface 14a of the heat sink 14 with which the solder joint layer 34 is in contact mainly comprises copper-based metallic material. Accordingly, the solder joint layer 34 has a second compound layer 34c mainly comprising copper-tin based intermetallic compound (e.g., Cu₆Sn₅) at an interface with the heat sink 14. Moreover, the solder joint layer 34 has an intermediate layer 34b made of an alloy (i.e., solder) mainly comprising tin between the first compound layer 34a and the second compound layer 34c.

As mentioned above, when the electric current C flows in the semiconductor device 10 (see FIG. 1), the temperature of the semiconductor element 20 and the temperature of the heat sink 14 rise. The semiconductor element 20, in particular, generates a larger amount of heat than the heat sink 14, and hence the temperature of the semiconductor element 20 tends to be higher than that of the heat sink 14. Consequently, the temperature of the solder joint layer 34 becomes high on the semiconductor element 20 side, and becomes low on the heat sink 14 side. Accordingly, at the interface between the solder joint layer 34 and the second electrode 22, nickel diffuses from the nickel film 22a to the solder joint layer 34, to thereby allow the first compound layer 34a to be grown easily. If the temperature near an interface between the nickel film 22a and the solder joint layer 34 becomes at 150°C or higher, in particular, the growth of the first compound layer 34a is remarkable. When the first compound layer 34a is kept grown, defects such as voids occur inside or in proximity of the first compound layer 34a. Such defects can cause malfunctions such as a decrease in joint strength, an increase in electrical resistance, and the like. On the other hand, at the interface between the solder joint layer 34 and the heat sink 14, the temperature thereof is relatively low, and hence growth of the second compound layer 34c is relatively small. The heat sink 14 is exposed on a surface of the seal body 12, in particular, and hence the temperature rise of the heat sink 14 is small. The growth of the second compound layer 34c is thereby suppressed significantly. Accordingly, to improve durability of the solder joint layer 34, it is important to suppress the growth of the first compound layer 34a at the interface between the second electrode 22 of the semiconductor element 20 and the solder joint layer 34.

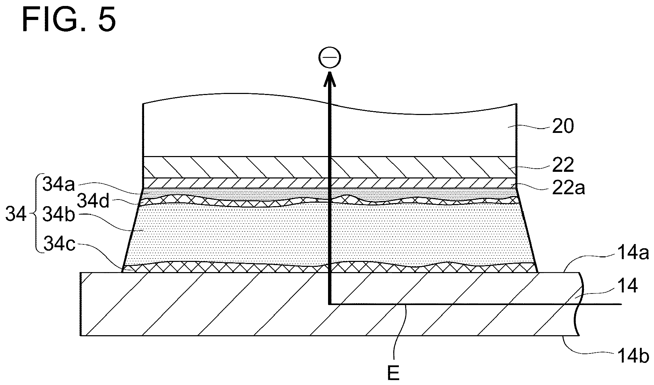

Regarding the above-described aspects, according to the semiconductor device 10 in the present embodiment, a barrier layer 34d is formed, as shown in FIG. 5, on the first compound layer 34a in a process of using the semiconductor device 10. The barrier layer 34d mainly comprises copper-tin based intermetallic compound (e.g., Cu₆Sn₅). When the first compound layer 34a is covered with the copper-tin based intermetallic compound, diffusion of nickel from the nickel film 22a to the solder joint layer 34 is suppressed. Accordingly, growth of the first compound layer 34a is suppressed by the barrier layer 34d formed on the first compound layer 34a, and durability of the semiconductor device 10 can be enhanced.

Here, the mechanism of formation of the barrier layer 34d will be described. As mentioned above, the semiconductor element 20 is a diode, and allows electric current that flows from the first electrode 21 (the anode electrode) to the second electrode 22 (the cathode electrode) on one hand, and prevents electric current that flows from the second electrode 22 to the first electrode 21 on the other hand. Accordingly, in the solder joint layer 34 joined with the second electrode 22 of the semiconductor element 20, only the electric current that goes from the semiconductor element 20 toward the heat sink 14 can flow. In other words, in the solder joint layer 34, electrons always flow from the heat sink 14 toward the semiconductor element 20, and do not flow in a direction reverse thereto. An arrow E in FIG. 5 schematically shows a flow of electrons. When electrons flow from the heat sink 14 toward the semiconductor element 20, the copper-tin based intermetallic compound that configures the second compound layer 34c moves toward the first compound layer 34a due to electromigration, and is deposited on the first compound layer 34a. Consequently, as shown in FIG. 5, the barrier layer 34d is formed on the first compound layer 34a. The semiconductor element 20 in the present embodiment, in particular, is an element that uses silicon carbide, and has an allowable electric current density of 25 A/mm² or higher. If the density of electric current that flows in the semiconductor element 20 is 25 A/mm² or higher, formation of the barrier layer 34d due to electromigration is remarkable.

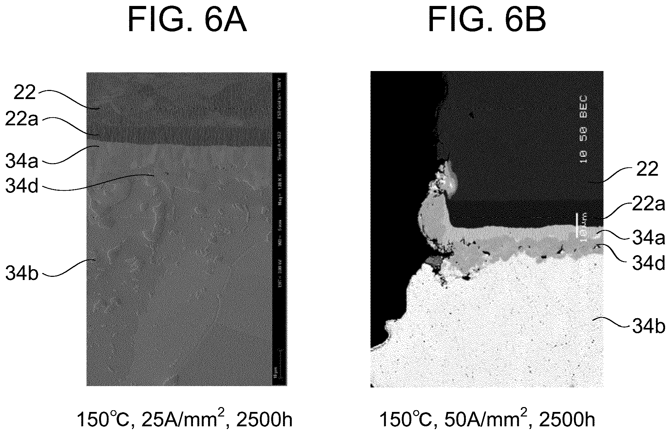

FIG. 6 is an electron microscopic photograph obtained by photographing the barrier layer 34d formed on the first compound layer 34a. FIG. 6A shows a sample of the semiconductor device 10 that was placed in an atmosphere at 150°C and allowed electric current to flow therein for 2500 hours at an electric current density of 25 A/mm². FIG. 6B shows a sample of the semiconductor device 10 that was placed in an atmosphere at 150°C and allowed electric current to flow therein for 2500 hours at an electric current density of 50 A/mm². In any of the photographs, both of the barrier layer 34d formed on the first compound layer 34a and the remaining nickel film 22a can be observed. In other words, it is observed that diffusion of nickel from the nickel film 22a is suppressed by the barrier layer 34d.

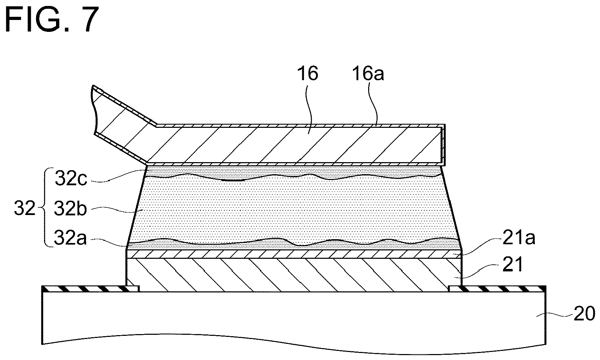

On the other hand, as shown in FIG. 7, the first electrode 21 of the semiconductor element 20 adopts a joint structure different from that of the second electrode 22. As mentioned above, the positive terminal 16 is covered with the nickel film 16a. Moreover, a surface of the first electrode 21 is also provided with a nickel film 21a. Accordingly, the solder joint layer 32 that joins the first electrode 21 and the positive terminal 16 has a compound layer 32a comprising nickel-tin based intermetallic compound (e.g., Ni₃Sn₄) at an interface with the first electrode 21. Moreover, the solder joint layer 32 also has a compound layer 32c comprising nickel-tin based intermetallic compound (e.g., Ni₃Sn₄) at an interface with the positive terminal 16. The solder joint layer 32 has an intermediate layer 32b comprising an alloy (i.e., solder) made mainly of tin between the two compound layers 32a and 32c. In the solder joint layer 32 located on the first electrode 21 side, electrons flow from the semiconductor element 20 toward the positive terminal 16, and hence formation of the barrier layer 34d due to electromigration cannot be achieved onto the compound layer 32a on the semiconductor element 20 side, where the growth of an intermetallic compound is remarkable. Accordingly, in a joint portion of the positive terminal 16 and the first electrode 21, both of the positive terminal 16 and the first electrode 21 are provided with the nickel films 16a and 21a, respectively.

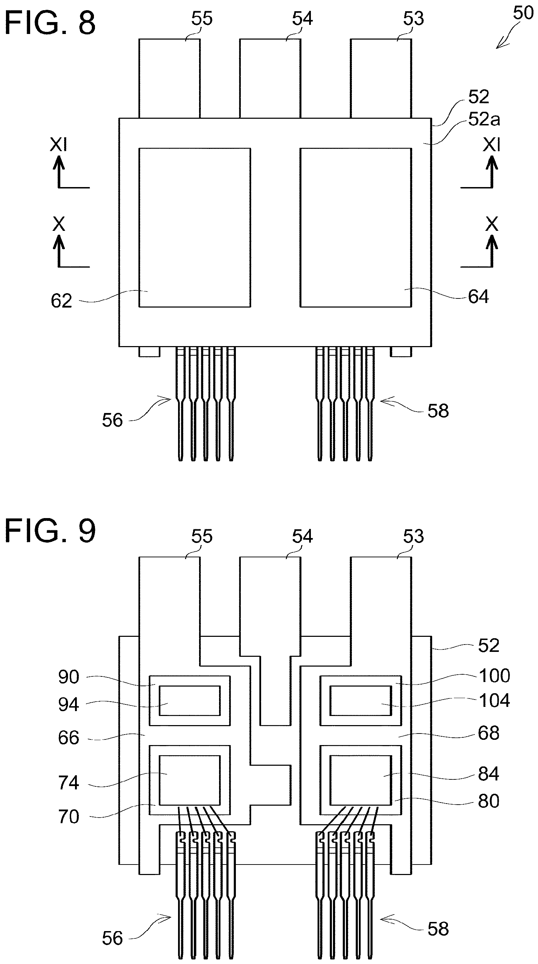

A semiconductor device 50 in Embodiment 2 will be described. As shown in FIGS. 8 to 12, the semiconductor device 50 includes a plurality of semiconductor elements 70, 80, 90, and 100, and a seal body 52 that seals the plurality of semiconductor elements 70, 80, 90, and 100 therein. Moreover, the semiconductor device 50 includes a plurality of heat sinks 62, 64, 66, and 68, and a plurality of spacers 74, 84, 94, and 104. The plurality of heat sinks 62, 64, 66, and 68 include a first heat sink 62, a second heat sink 64, a third heat sink 66, and a fourth heat sink 68. Each of the heat sinks 62, 64, 66, and 68 and each of the spacers 74, 84, 94, and 104 are electrically conductive members, and are formed of copper in the present embodiment. As mentioned below, each of the heat sinks 62, 64, 66, and 68 and each of the spacers 74, 84, 94, and 104 are electrically connected to one or the plurality of semiconductor elements 70, 80, 90, and 100, and configure an electrically conductive path in the semiconductor device 50. Moreover, the first heat sink 62 and the second heat sink 64 are exposed on an upper surface 52a of the seal body 52, and the third heat sink 66 and the fourth heat sink 68 are exposed on a lower surface 52b of the seal body 52. Heat generated inside the semiconductor device 50 is thereby dissipated to an outside via the plurality of heat sinks 62, 64, 66, and 68.

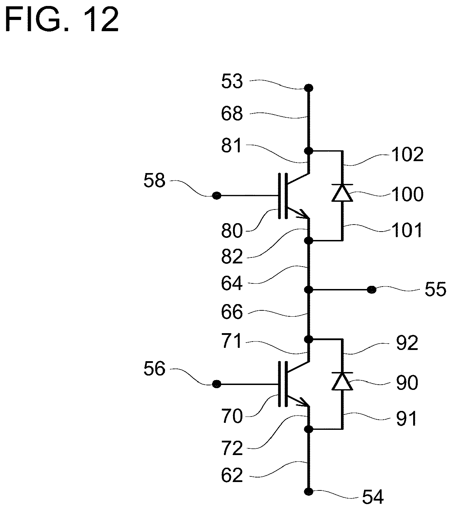

The plurality of semiconductor elements 70, 80, 90, and 100 include a first transistor 70, a second transistor 80, a first diode 90, and a second diode 100 (see FIG. 12). The first transistor 70 and the second transistor 80 are electrically connected in series. The first diode 90 is electrically connected to the first transistor 70 in reverse parallel, and the second diode 100 is electrically connected to the second transistor 80 in reverse parallel.

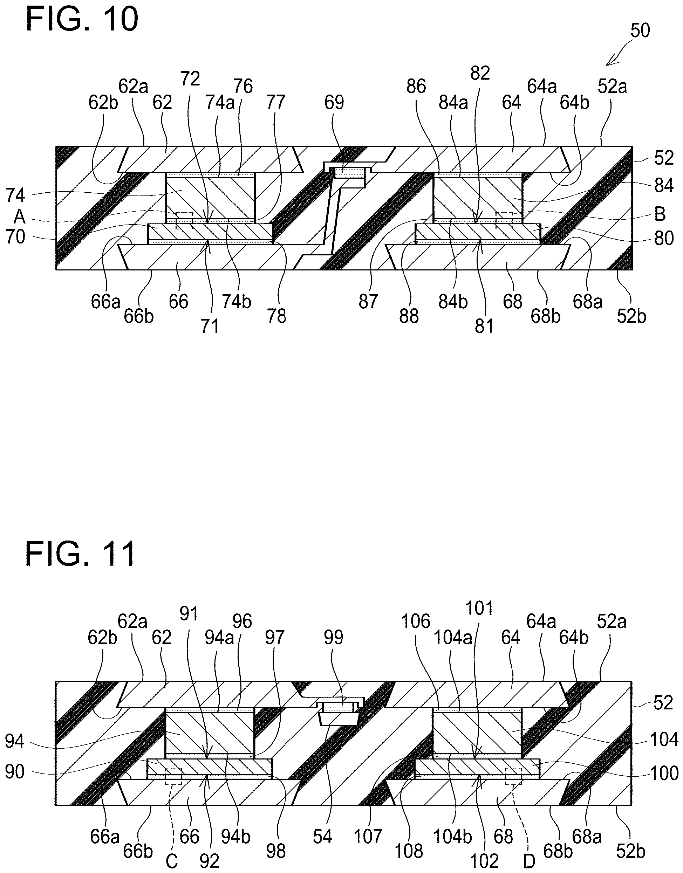

As shown in FIGS. 10 and 12, the first transistor 70 includes a first electrode 71 and a second electrode 72. The first electrode 71 is located on a lower surface of the first transistor 70, and the second electrode 72 is located on an upper surface of the first transistor 70. The first transistor 70 is a bipolar transistor, or specifically an IGBT (Insulated Gate Bipolar Transistor), the first electrode 71 is a collector electrode of the IGBT, and the second electrode 72 is an emitter electrode of the IGBT. Accordingly, the first transistor 70 allows electric current to flow from the first electrode 71 to the second electrode 72 and prevents electric current from flowing from the second electrode 72 to the first electrode 71. The first transistor 70 belongs to the power semiconductor element, and its allowable electric current density is 25 A/mm² or higher.

The first electrode 71 (the collector electrode) of the first transistor 70 is soldered to an upper surface 66a of the third heat sink 66, and joined with the upper surface 66a of the third heat sink 66 via a solder joint layer 78. The second electrode 72 (the emitter electrode) of the first transistor 70 is soldered to a lower surface 74b of the spacer 74, and joined with the lower surface 74b of the spacer 74 via a solder joint layer 77. An upper surface 74a of the spacer 74 is soldered to a lower surface 62b of the first heat sink 62, and joined with the lower surface 62b of the first heat sink 62 via a solder joint layer 76. The first electrode 71 of the first transistor 70 is thereby electrically connected to the third heat sink 66, and the second electrode 72 of the first transistor 70 is thereby electrically connected to the first heat sink 62 via the spacer 74.

The second transistor 80 has a configuration similar to that of the first transistor 70. In other words, the second transistor 80 includes a first electrode 81 and a second electrode 82. The first electrode 81 is located on a lower surface of the second transistor 80, and the second electrode 82 is located on an upper surface of the second transistor 80. The second transistor 80 is an IGBT (Insulated Gate Bipolar Transistor), the first electrode 81 is a collector electrode of the IGBT, and the second electrode 82 is an emitter electrode of the IGBT. Accordingly, the second transistor 80 allows electric current to flow from the first electrode 81 to the second electrode 82 and prevents electric current from flowing from the second electrode 82 to the first electrode 81. The second transistor 80 belongs to the power semiconductor element, and its allowable electric current density is 25 A/mm² or higher.

The first electrode 81 (the collector electrode) of the second transistor 80 is soldered to an upper surface 68a of the fourth heat sink 68, and joined with the upper surface 68a of the fourth heat sink 68 via a solder joint layer 88. The second electrode 82 (the emitter electrode) of the second transistor 80 is soldered to a lower surface 84b of the spacer 84, and joined with the lower surface 84b of the spacer 84 via a solder joint layer 87. An upper surface 84a of the spacer 84 is soldered to a lower surface 64b of the second heat sink 64, and joined with the lower surface 64b of the second heat sink 64 via a solder joint layer 86. The first electrode 81 of the second transistor 80 is thereby electrically connected to the fourth heat sink 68, and the second electrode 82 of the second transistor 80 is thereby electrically connected to the second heat sink 64 via the spacer 84.

As shown in FIGS. 11 and 12, the first diode 90 includes a first electrode 91 and a second electrode 92. The first electrode 91 is located on an upper surface of the first diode 90, and the second electrode 92 is located on a lower surface of the first diode 90. The first electrode 91 is an anode electrode of the first diode 90, and the second electrode 92 is a cathode electrode of the first diode 90. Accordingly, the first diode 90 allows electric current to flow from the first electrode 91 to the second electrode 92 and prevents electric current from flowing from the second electrode 92 to the first electrode 91. As one example, the first diode 90 is a power semiconductor element that uses silicon carbide (SiC), and its allowable electric current density is 25 A/mm² or higher.

The first electrode 91 (the anode electrode) of the first diode 90 is soldered to a lower surface 94b of the spacer 94, and joined with the lower surface 94b of the spacer 94 via a solder joint layer 97. An upper surface 94a of the spacer 94 is soldered to the lower surface 62b of the first heat sink 62, and joined with the lower surface 62b of the first heat sink 62 via a solder joint layer 96. The second electrode 92 (the cathode electrode) of the first diode 90 is soldered to the upper surface 66a of the third heat sink 66, and joined with the upper surface 66a of the third heat sink 66 via a solder joint layer 98. The first electrode 91 of the first diode 90 is thereby electrically connected to the first heat sink 62 via the spacer 94, and the second electrode 92 of the first diode 90 is thereby electrically connected to the third heat sink 66. Moreover, the first diode 90 is connected to the first transistor 70 in reverse parallel, via the first heat sink 62 and the third heat sink 66.

The second diode 100 has a configuration similar to that of the first diode 90. In other words, the second diode 100 includes a first electrode 101 and a second electrode 102. The first electrode 101 is located on an upper surface of the second diode 100, and the second electrode 102 is located on a lower surface of the second diode 100. The first electrode 101 is an anode electrode of the second diode 100, and the second electrode 102 is a cathode electrode of the second diode 100. Accordingly, the second diode 100 allows electric current to flow from the first electrode 101 to the second electrode 102 and prevents electric current from flowing from the second electrode 102 to the first electrode 101. The allowable electric current density of the second diode 100 is also 25 A/mm² or higher.

The first electrode 101 (the anode electrode) of the second diode 100 is soldered to a lower surface 104b of the spacer 104, and joined with the lower surface 104b of the spacer 104 via a solder joint layer 107. An upper surface 104a of the spacer 104 is soldered to the lower surface 64b of the second heat sink 64, and joined with the lower surface 64b of the second heat sink 64 via a solder joint layer 106. The second electrode 102 (the cathode electrode) of the second diode 100 is soldered to the upper surface 68a of the fourth heat sink 68, and joined with the upper surface 68a of the fourth heat sink 68 via a solder joint layer 108. The first electrode 101 of the second diode 100 is thereby electrically connected to the second heat sink 64 via the spacer 104, and the second electrode 102 of the second diode 100 is thereby electrically connected to the fourth heat sink 68. Moreover, the second diode 100 is connected to the second transistor 80 in reverse parallel, via the second heat sink 64 and the fourth heat sink 68.

The semiconductor device 50 further includes a positive terminal 53, a negative terminal 54, an output terminal 55, and a plurality of control terminals 56 and 58. The positive terminal 53 is formed integrally with the fourth heat sink 68, and electrically connected to the fourth heat sink 68. The negative terminal 54 is joined with the first heat sink 62 via a solder joint layer 99 (see FIG. 11), and electrically connected to the first heat sink 62. The output terminal 55 is formed integrally with the third heat sink 66, and electrically connected to the third heat sink 66. Moreover, the second heat sink 64 is joined with the third heat sink 66 via a solder joint layer 69 (see FIG. 10), and electrically connected to the third heat sink 66. The first transistor 70 and the second transistor 80 are thereby connected in series between the positive terminal 53 and the negative terminal 54, and a midpoint between the first transistor 70 and the second transistor 80 is electrically connected to the output terminal 55. The plurality of control terminals 56 and 58 are electrically connected to signal pads (not shown), such as gate pads, provided at the first transistor 70 and the second transistor 80, respectively.

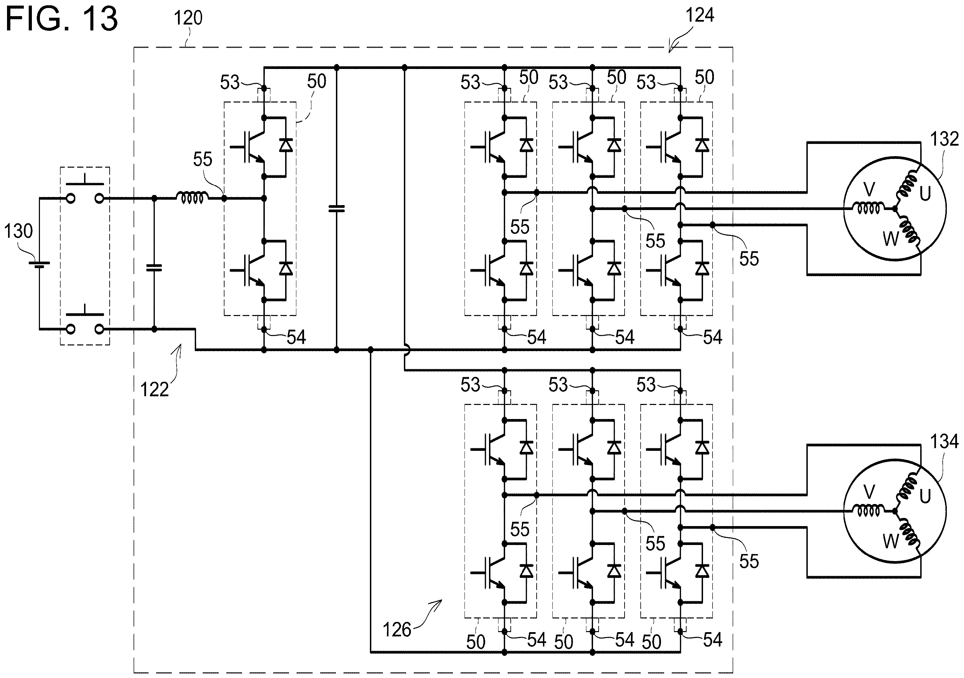

The semiconductor device 50 in the present embodiment can be used in an electric power control device 120 shown in FIG. 13, as one example. The electric power control device 120 is typically mounted on an electric vehicle (that includes a hybrid car and a fuel-cell vehicle). The electric power control device 120 controls driving electric power supplied from a battery 130 to motors 132 and 134. Moreover, when each of the motors 132 and 134 functions as an electric generator, the electric power control device 120 controls charging electric power supplied from the motors 132 and 134 to the battery 130. The electric power control device 120 includes a step-up/step-down converter 122, and two inverters 124 and 126. The step-up/step-down converter 122 steps up electric power from the battery 130, and supplies the stepped-up electric power to the inverters 124 and 126. Moreover, the step-up/step-down converter 122 steps down electric power from the inverters 124 and 126, and supplies the stepped-down electric power to the battery 130. The inverters 124 and 126 convert the direct-current electric power supplied from the step-up/step-down converter 122 into alternating-current electric power, and supply the alternating-current electric power to the motors 132 and 134, respectively. Moreover, the inverters 124 and 126 convert the alternating-current electric power supplied from the motors 132 and 134 into direct-current electric power, and supply the direct-current electric power to the step-up/step-down converter 122. As shown in FIG. 13, in the electric power control device 120, one semiconductor device 50 is used in the step-up/step-down converter 122, and three semiconductor devices 50 are used in each of the inverters 124 and 126.

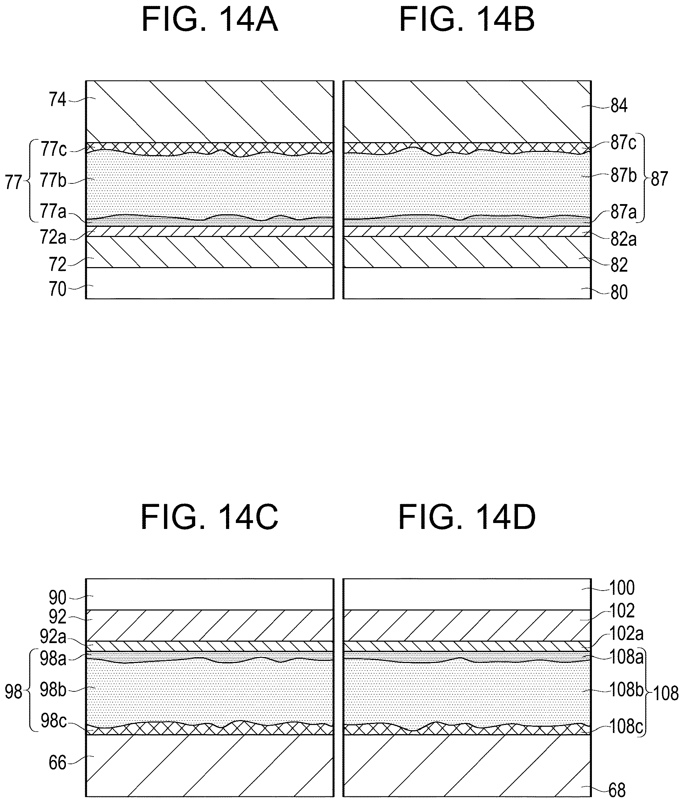

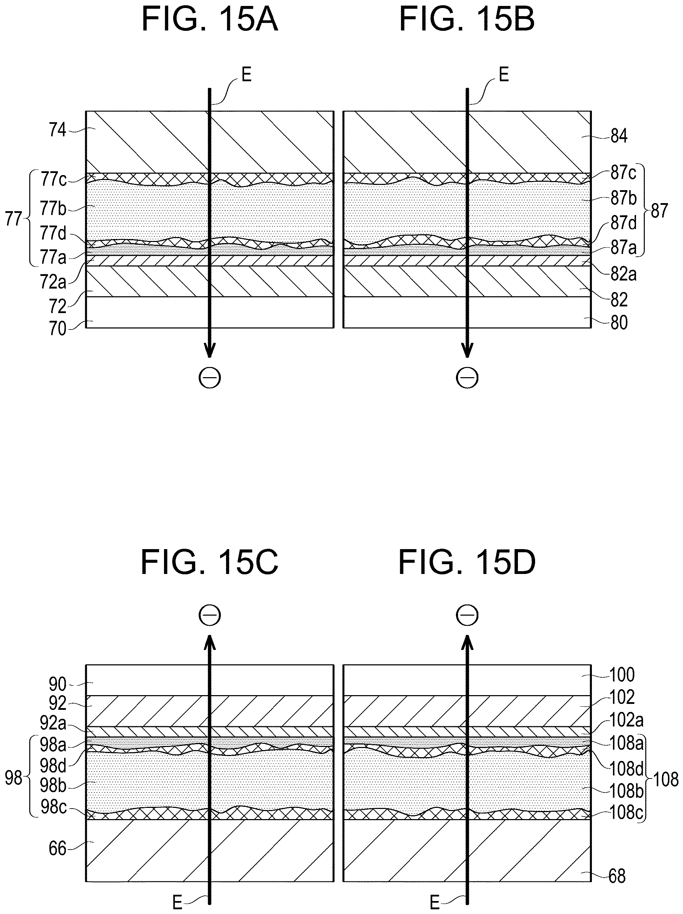

Next, with reference to FIGS. 14A-14D and 15A-15D, a joint structure by the solder joint layer 77 between the second electrode 72 of the first transistor 70 and the spacer 74 will be described. As shown in FIG. 14A, the second electrode 72 (the emitter electrode) of the first transistor 70 has a nickel film 72a, and a surface of the second electrode 72 in contact with the solder joint layer 77 mainly comprises nickel. Accordingly, the solder joint layer 77 has a first compound layer 77a comprising nickel-tin based intermetallic compound (e.g., Ni₃Sn₄) at an interface with the second electrode 72. On the other hand, a surface of the spacer 74 with which the solder joint layer 77 is in contract mainly comprises copper. Accordingly, the solder joint layer 77 has a second compound layer 77c comprising copper-tin based intermetallic compound (e.g., Cu₆Sn₅) at an interface with the spacer 74. Moreover, the solder joint layer 77 has an intermediate layer 77b comprising an alloy (i.e., solder) made mainly of tin between the first compound layer 77a and the second compound layer 77c.

When electric current flows in the semiconductor device 50, the temperature of the first transistor 70 and the temperature of the spacer 74 rise. The first transistor 70, in particular, generates a larger amount of heat than the spacer 74, and hence the temperature of the first transistor 70 tends to be higher than that of the spacer 74. Consequently, the temperature of the solder joint layer 77 becomes high on the first transistor 70 side, and becomes low on the spacer 74 side. Accordingly, at the interface between the solder joint layer 77 and the second electrode 72, nickel diffuses from the nickel film 72a to the solder joint layer 77, to thereby allow the first compound layer 77a to be grown easily. On the other hand, at the interface between the solder joint layer 77 and the spacer 74, the temperature thereof is relatively low, and hence growth of the second compound layer 77c is relatively small. Accordingly, to enhance durability of the semiconductor device 50, it is important to suppress the growth of the first compound layer 77a in the solder joint layer 77.

Regarding the above-described aspects, according to the semiconductor device 50 in the present embodiment, a barrier layer 77d is formed, as shown in FIG. 15A, on the first compound layer 77a in a process of using the semiconductor device 50. The barrier layer 77d comprises copper-tin based intermetallic compound (e.g., Cu₆Sn₅). When the first compound layer 77a is covered with the copper-tin based intermetallic compound, diffusion of nickel from the nickel film 72a to the solder joint layer 77 is suppressed. Accordingly, growth of the first compound layer 77a is suppressed by the barrier layer 77d formed on the first compound layer 77a, and durability of the semiconductor device 50 can be enhanced. The mechanism of formation of the barrier layer 77d is similar to that described in Embodiment 1. In other words, the first transistor 70 allows electric current that flows from the first electrode 71 (the collector electrode) to the second electrode 72 (the emitter electrode) on one hand, and prevents electric current that flows from the second electrode 72 to the first electrode 71 on the other hand. Accordingly, as shown by an arrow E in FIG. 15A, in the solder joint layer 77, electrons always flow from the spacer 74 toward the first transistor 70, and do not flow in a direction reverse thereto. With this flow E of electrons, the copper-tin based intermetallic compound that configures the second compound layer 77c moves toward the first compound layer 77a due to electromigration, and is deposited on the first compound layer 77a. Consequently, as shown in FIG. 15A, the barrier layer 77d is formed on the first compound layer 77a.

As shown in FIG. 14B, the above-mentioned joint structure is also adopted in a joint portion by the solder joint layer 87 between the second electrode 82 (the emitter electrode) of the second transistor 80 and the spacer 84. In other words, the second electrode 82 of the second transistor 80 has a nickel film 82a on its surface. Accordingly, the solder joint layer 87 has a first compound layer 87a comprising of nickel-tin based intermetallic compound (e.g., Ni₃Sn₄) at an interface with the second electrode 82. On the other hand, a surface of the spacer 84 with which the solder joint layer 87 is in contact comprises copper-based metallic material Accordingly, the solder joint layer 87 has a second compound layer 87c comprising copper-tin based intermetallic compound (e.g., Cu₆Sn₅) at an interface with the spacer 84. Moreover, the solder joint layer 87 has an intermediate layer 87b comprising an alloy (i.e., solder) made mainly of tin between the first compound layer 87a and the second compound layer 87c.

The second transistor 80 allows electric current that flows from the first electrode 81 (the collector electrode) to the second electrode 82 (the emitter electrode) on one hand, and prevents electric current that flows from the second electrode 82 to the first electrode 81 on the other hand. Accordingly, as shown by an arrow E in FIG. 15B, in the solder joint layer 87, electrons always flow from the spacer 84 toward the second transistor 80, and do not flow in a direction reverse thereto. With this flow E of electrons, the copper-tin based intermetallic compound that configures the second compound layer 87c moves toward the first compound layer 87a due to electromigration, and is deposited on the first compound layer 87a. Consequently, as shown in FIG. 15B, a barrier layer 87d comprises the copper-tin based intermetallic compound is formed on the first compound layer 87a. Consequently, growth of the first compound layer 87a is suppressed.

As shown in FIG. 14C, a similar joint structure is also adopted in a joint portion by the solder joint layer 98 between the second electrode 92 (the cathode electrode) of the first diode 90 and the third heat sink 66. In other words, the second electrode 92 of the first diode 90 has a nickel film 92a on its surface. Accordingly, the solder joint layer 98 has a first compound layer 98a comprises nickel-tin based intermetallic compound (e.g., Ni₃Sn₄) at an interface with the second electrode 92. On the other hand, a surface of the third heat sink 66 with which the solder joint layer 98 is in contact is made of copper. Accordingly, the solder joint layer 98 has a second compound layer 98c comprises copper-tin based intermetallic compound (e.g., Cu₆Sn₅) at an interface with the third heat sink 66. Moreover, the solder joint layer 98 has an intermediate layer 98b made of an alloy (i.e., solder) composed mainly of tin between the first compound layer 98a and the second compound layer 98c.

The first diode 90 allows electric current that flows from the first electrode 91 (the anode electrode) to the second electrode 92 (the cathode electrode) on one hand, and prevents electric current that flows from the second electrode 92 to the first electrode 91 on the other hand. Accordingly, as shown by an arrow E in FIG. 15C, in the solder joint layer 98, electrons always flow from the third heat sink 66 toward the first diode 90, and do not flow in a direction reverse thereto. With this flow E of electrons, the copper-tin based intermetallic compound that configures the second compound layer 98c moves toward the first compound layer 98a due to electromigration, and is deposited on the first compound layer 98a. Consequently, as shown in FIG. 15C, a barrier layer 98d comprises the copper-tin based intermetallic compound is formed on the first compound layer 98a. Consequently, growth of the first compound layer 98a is suppressed.

As shown in FIG. 14D, a similar joint structure is also adopted in a joint portion by the solder joint layer 108 between the second electrode 102 (the cathode electrode) of the second diode 100 and the fourth heat sink 68. In other words, the second electrode 102 of the second diode 100 has a nickel film 102a on its surface. Accordingly, the solder joint layer 108 includes a first compound layer 108a comprising nickel-tin based intermetallic compound (e.g., Ni₃Sn₄) at an interface with the second electrode 102. On the other hand, a surface of the fourth heat sink 68 with which the solder joint layer 108 is in contact is made of copper. Accordingly, the solder joint layer 108 has a second compound layer 108c comprising copper-tin based intermetallic compound (e.g., Cu₆Sn₅) at an interface with the fourth heat sink 68. Moreover, the solder joint layer 108 includes an intermediate layer 108b made of an alloy (i.e., solder) composed mainly of tin between the first compound layer 108a and the second compound layer 108c.

The second diode 100 also allows electric current that flows from the first electrode 101 (the anode electrode) to the second electrode 102 (the cathode electrode) on one hand, and prevents electric current that flows from the second electrode 102 to the first electrode 101 on the other hand. Accordingly, as shown by an arrow E in FIG. 15D, in the solder joint layer 108, electrons always flow from the fourth heat sink 68 toward the second diode 100, and do not flow in a direction reverse thereto. With this flow E of electrons, the copper-tin based intermetallic compound that configures the second compound layer 108c moves toward the first compound layer 108a due to electromigration, and is deposited on the first compound layer 108a. Consequently, as shown in FIG. 15D, a barrier layer 108d comprises the copper-tin based intermetallic compound is formed on the first compound layer 108a. Consequently, growth of the first compound layer 108a is suppressed.

The present disclosure includes the following semiconductor device. The semiconductor device (10; 50) comprises a semiconductor element (20; 70; 80; 90; 100) and an electrically conductive member (14; 66; 68; 74; 84). The semiconductor element includes a first electrode (21; 71; 81; 91; 101) and a second electrode (22; 72; 82; 92; 102), and is configured to allow electric current to flow from the first electrode to the second electrode and prevent electric current flowing from the second electrode to the first electrode. The electrically conductive member is joined with the second electrode of the semiconductor element via a solder joint layer (34; 77; 87; 98; 108). A surface of the second electrode in contact with the solder joint layer is made of metallic material (22a; 72a; 82a; 92a; 102a) at least mainly comprising nickel. A surface of the conductive member in contact with the solder joint layer is made of metallic material (14a; 66a; 68a; 74b; 84b) at least mainly comprising copper. The solder joint layer comprises a first compound layer (34a; 77a; 87a; 98a; 108a) and a second compound layer (34c; 77c; 87c; 98c; 108c). The first compound layer is located at an interface with the second electrode and comprises nickel-tin based intermetallic compound. The second compound layer is located at an interface with the conductive member and comprises copper-tin based intermetallic compound. According to such a configuration, in a process of using the semiconductor device, the barrier layer (34d, 77d, 87d, 98d, 108d) mainly comprising copper-tin based intermetallic compound is formed on the first compound layer located at the interface between the second electrode of the semiconductor element and the solder joint layer. It is thereby possible to suppress growth of the intermetallic compound at the interface between the second electrode of the semiconductor element and the solder joint layer.

In an exemplary embodiment, the semiconductor element may include a diode (20; 90; 100), the first electrode may include an anode electrode (21; 91; 101) of the diode and the second electrode may include a cathode electrode (22; 92; 102) of the diode. The diode allows electric current to flow from the anode electrode to the cathode electrode and prevents electric current from flowing from the cathode electrode to the anode electrode. Accordingly, the art disclosed herein can suitably be adopted in a semiconductor device that includes a diode as a semiconductor element.

In an exemplary embodiment, the semiconductor element may include an IGBT (70; 80), the first electrode may include a collector electrode (71; 81) of the IGBT and the second electrode may include an emitter electrode (72; 82) of the IGBT. The IGBT allows electric current to flow from the collector electrode to the emitter electrode and prevents electric current from flowing from the emitter electrode to the collector electrode. Accordingly, the art disclosed herein can suitably be adopted in a semiconductor device that includes an IGBT as a semiconductor element.

In an exemplary embodiment, the semiconductor device may further include a seal body (12, 52) configured to seal the semiconductor element therein, and the electrically conductive member may be a heat sink (14, 66, 68) at least partly exposed on a surface of the seal body. According to such a configuration, the temperature rise at the interface between the electrically conductive member and the solder joint layer is further suppressed, and generation of the intermetallic compound at that interface (i.e., growth of the second compound layer) is further reduced.

A semiconductor device includes a semiconductor element and an electrically conductive member. The semiconductor element is configured to allow an electric current to flow from a first electrode to a second electrode and prevent an electric current flowing from the second electrode to the first electrode. The conductive member is joined with the second electrode via a solder joint layer. Surface of the second electrode in contact with the solder joint layer mainly comprises nickel, and surface of the conductive member in contact with the solder joint layer mainly comprises copper. The solder joint layer comprises first and second compound layers. The first compound layer is located at an interface with the second electrode and comprises nickel-tin based intermetallic compound. The second compound layer is located at an interface with the conductive member and comprises copper-tin based intermetallic compound.

## Claims

1. A semiconductor device (10; 50) comprising:
a semiconductor element (20; 70; 80; 90; 100) including a first electrode (21; 71; 81; 91; 101) and a second electrode (22; 72; 82; 92; 102), the semiconductor element (20; 70; 80; 90; 100) being configured to allow electric current to flow from the first electrode (21; 71; 81; 91; 101) to the second electrode (22; 72; 82; 92; 102) and prevent electric current flowing from the second electrode (22; 72; 82; 92; 102) to the first electrode (21; 71; 81; 91; 101); and
an electrically conductive member (14; 66; 68; 74; 84) joined with the second electrode (22; 72; 82; 92; 102) of the semiconductor element (20; 70; 80; 90; 100) via a solder joint layer (34; 77; 87; 98; 108),
wherein a surface of the second electrode (22; 72; 82; 92; 102) in contact with the solder joint layer (34; 77; 87; 98; 108) is made of metallic material mainly comprising nickel,
a surface of the electrically conductive member (14; 66; 68; 74; 84) in contact with the solder joint layer (34; 77; 87; 98; 108) is made of metallic material mainly comprising copper, and
the solder joint layer (34; 77; 87; 98; 108) comprises a first compound layer (34a; 77a; 87a; 98a; 108a) and a second compound layer (34c; 77c; 87c; 98c; 108c), the first compound layer (34a; 77a; 87a; 98a; 108a) being located at an interface with the second electrode (22; 72; 82; 92; 102) and comprising nickel-tin based intermetallic compound and the second compound layer being located at an interface with the electrically conductive member (14; 66; 68; 74; 84) and comprising copper-tin based intermetallic compound.

2. The semiconductor device (10; 50) according to claim 1, wherein the semiconductor element (20; 90; 100) includes a diode, the first electrode (21; 91; 101) includes an anode electrode of the diode and the second electrode (22; 92; 102) includes a cathode electrode of the diode.

3. The semiconductor device (50) according to claim 1, wherein the semiconductor element (70; 80) includes an IGBT, the first electrode (71; 81) includes a collector electrode of the IGBT and the second electrode (72; 82) includes an emitter electrode of the IGBT.

4. The semiconductor device (10; 50) according to any one of claims 1 to 3, further comprising a seal body (12, 52) configured to seal the semiconductor element (20; 70; 80; 90; 100) therein, wherein the electrically conductive member (14; 66; 68; 74; 84) is a heat sink at least partly exposed on a surface of the seal body (12, 52).
